# EUROPÄISCHE PATENTSCHRIFT

(11) **EP 1 116 276 B1**
(45) Veröffentlichungstag und Bekanntmachung des Hinweises auf die Patenterteilung: **16.01.2008**
(21) Anmeldenummer: 99953648.5
(22) Anmeldetag: 01.09.1999
(51) Int. Cl.: H01L 29/06, H01L 29/861, H01L 29/739

(54) **HALBLEITERBAUELEMENT MIT FELDFORMUNGSGEBIETEN**
SEMICONDUCTOR COMPONENT WITH FIELD-FORMING REGIONS
COMPOSANT SEMI-CONDUCTEUR COMPORTANT DES REGIONS DE MISE EN FORME DE CHAMP

(30) Priorität: 23.09.1998 DE 19843659
(43) Veröffentlichungstag der Anmeldung: 18.07.2001
(73) Patentinhaber: Infineon Technologies AG, 81669 München (DE)
(72) Erfinder: BRUNNER, Heinrich, D-84405 Dorfen (DE); TIHANYI, Jenö, D-85551 Kirchheim (DE); AUERBACH, Franz, D-81827 München (DE)
(74) Vertreter: Bickel, Michael
(86) Internationale Anmeldenummer: PCT/DE1999/002732
(87) Internationale Veröffentlichungsnummer: WO 2000/017931

(56) Entgegenhaltungen:
- EP-A- 0 344 514

## Beschreibung

Die vorliegende Erfindung betrifft ein Halbleiterbauelement mit einem Halbleiterkörper des einen Leitungstyps, der eine Dotierungskonzentration über 5 x 10¹³ Ladungsträger cm⁻³ aufweist und auf zwei einander gegenüberliegenden Oberflächen mit jeweils wenigstens einer Elektrode versehen ist, wobei wenigstens eine dieser Elektroden eine Halbleiterzone eines zweiten, zum einen Leitungstyp entgegengesetzten Leitungstyps kontaktiert; die Erfindung bezieht sich insbesondere auf eine Randstruktur für ein solches Halbleiterbauelement.

Bekanntlich beträgt die minimale Grunddotierung von Silizium-Leistungsbauelementen etwa 8 x 10¹² Ladungsträger cm⁻³ . Bei einer solchen Grunddotierung liegt die Volumensperrspannung eines einen pn-Übergang aufweisenden Halbleiterkörpers bei Raumtemperatur in der Größenordnung von 10 kV.

Bei monokristallinem Silizium beträgt die eigenleitende bzw. intrinsische Dichte bei 300°K, also bei Raumtemperatur, von thermisch generierten Elektron-Loch-Paaren etwa 1,38 x 10¹⁰ Ladungsträger cm⁻³. Eine solche Konzentration in der Größenordnung von 10¹⁰ Ladungsträger cm⁻³ ist gewöhnlich vernachlässigbar gegenüber der um nahezu drei Größenordnungen höheren Grunddotierung von 8 x 10¹² Ladungsträger cm⁻³ .

Es ist jedoch zu bedenken, daß die intrinsische Dichte exponentiell mit der Temperatur ansteigt, so daß bei niedrigen Dotierungen die intrinsische Dichte die Grunddotierung erreichen kann. So entspricht beispielsweise einer Grunddotierung von etwa 1 x 10¹³ Ladungsträger cm⁻³ eine intrinsische Dichte, die bereits bei einer Temperatur von 150°C (in diesem Fall "intrinsische Temperatur") erreicht wird. Mit anderen Worten, liegt die Temperatur des Halbleiterbauelements im intrinsischen Bereich, so erhöht sich der Sperrstrom drastisch infolge der thermisch generierten Elektron-Loch-Paare.

Diese physikalischen Vorgaben schränken die Einsatzmöglichkeiten von Halbleiterbauelementen in der Starkstromtechnik, in der Spannungen bis zu 20 kV und darüber auftreten, an sich ein. Um dennoch so hohe Spannungen beherrschen zu können, werden Reihenschaltungen mehrerer Halbleiterbauelemente eingesetzt. Außerdem wird darauf geachtet, bei Halbleiterbauelementen mit niedriger Grunddotierung unter beispielsweise 1 x 10¹³ cm⁻³ Ladungsträger in Silizium die maximale Betriebstemperatur nicht über etwa 100°C ansteigen zu lassen, um so hohe Sperrströme infolge steigender intrinsischer Dichte zu vermeiden.

Aus EP-A-0 344 514 ist ein abschaltbarer Thyristor mit einem Halbleiterkörper bekannt, der eine von einer kathodenseitigen Elektrode kontaktierte n-Emitterschicht mit einer angrenzenden p-Basisschicht und eine von einer anodenseitigen Elektrode kontaktierte p-Emitterschicht mit einer angrenzenden n-Basisschicht aufweist, wobei die Basisschichten durch einen im blockierenden Zustand des Thyristors sperrenden pn-übergang voneinander getrennt sind. Eine der Basisschichten ist mit einer Gateelektrode versehen, der ein die Abschaltung des Thyristors bewirkender Löschspannungsimpuls zuführbar ist. In die von der Gateelektrode nicht kontaktierte Basisschicht ist wenigstens eine nicht mit äußeren Potentialen beschaltete, im wesentlichen parallel zum pn-Übergang verlaufende, zu dieser Basisschicht entgegengesetzt dotierte, im Vergleich zu der Dicke des Halbleiterkörpers dünne Halbleiterschicht eingefügt, deren Abstand von dem pn-Übergang so klein gewählt ist, daß die maximale Feldstärke der sich beim Abschalten des Thyristors an diesem pn-Übergang aufbauenden Raumladungszone auf einen Wert begrenzt wird, der unter einem kritischen Wert liegt, welcher zu einem Lawinendurchbruch bezüglich der beim Abschalten auszuräumenden Ladungsträger führt. Die in eine Basisschicht eingefügten, zu dieser entgegengesetzt dotierten Halbleiterschichten sind mit durchgehenden Ausnehmungen versehen, deren Abmessungen in lateraler Richtung klein gegenüber der Dicke der jeweils angrenzenden, sich bei Abschaltung des Thyristors aufbauenden Raumladungszonen sind. Die Ausnehmungen können dabei so angeordnet sein, daß sich eine gitterförmige Struktur dieser Halbleiterschichten ergibt. Durch die Ausnehmungen soll das Zündverhalten des Thyristors verbessert werden.

Es ist nun Aufgabe der vorliegenden Erfindung, ein Halbleiterbauelement zu schaffen, das sich durch eine hohe intrinsische Temperatur auszeichnet und so in der Lage ist, trotz hohen anliegenden Spannungen große Sperrströme zu vermeiden.

Diese Aufgabe wird bei einem Halbleiterbauelement der eingangs genannten Art erfindungsgemäß dadurch gelöst, daß in dem Halbleiterkörper im Abstand zur Zone des zweiten Leitungstyps diese Zone des zweiten Leitungstyps wannenartig umgebende und jeweils an wenigstens einer Stelle durch Kanäle des Halbleiterkörpers unterbrochene Gebiete des zweiten Leitungstyps vorgesehen sind, und daß die Gebiete des zweiten Leitungstyps so hoch dotiert sind, daß sie im Sperrfall des zwischen der Zone des zweiten Leitungstyp und dem Halbleiterkörper gebildeten pn-Überganges an Ladungsträgern nicht vollständig ausgeräumt sind.

Die Erfindung sieht also ein Halbleiterbauelement mit einem Halbleiterkörper des ersten Leitungstyps vor. In diesem Halbleiterkörper des ersten Leitungstyps sind Gebiete des zweiten Leitungstyps so eingebettet, daß eine beliebige Anzahl von Zonen des ersten Leitungstyps im Halbleiterkörper vorliegt, die eine Grunddotierung haben, die größer als 5 x 10¹³ Ladungsträger cm⁻³ ist. Diese Zonen des ersten Leitungstyps sind über Kanäle, die durch die Gebiete des zweiten Leitungstyps führen, miteinander verbunden. Die Dotierungskonzentration in den Gebieten des zweiten Leitungstyps ist so festgelegt, daß diese Gebiete im Sperrfall des Halbleiterbauelements nicht vollständig an Ladungsträgern ausgeräumt werden.

Die Gebiete des zweiten Leitungstyps sind vorzugsweise im Abstand wannenförmig um die Zone des zweiten Leitungstyps angeordnet und sind durch die Kanäle des ersten Leitungstyps unterbrochen. In den Zonen des ersten Leitungstyps bauen sich dann im Sperrfall elektrische Felder auf, die einen trapezförmigen Verlauf haben, wobei die Länge eines solchen "Feldstärketrapezes" durch die Länge der jeweiligen Zonen des ersten Leitungstyps, also durch den Abstand zwischen zwei benachbarten Gebieten des zweiten Leitungstyps, festgelegt wird. Durch Erhöhung der Anzahl der Gebiete des zweiten Leitungstyps, die jeweils durch die die Zonen des ersten Leitungstyps miteinander verbindenden Kanäle des ersten Leitungstyps unterbrochen sind, können beliebig viele "Feldstärketrapeze" aneinander gereiht werden, was zu einer entsprechenden Vergrößerung der Sperrspannung führt.

Durch die höhere Grunddotierung im Halbleiterkörper, also in den Zonen des ersten Leitungstyps, liegt die intrinsische Temperatur bedeutend höher als bei einem homogen dotierten Halbleiterkörper, wenn jeweils eine vergleichbare Sperrspannung anliegt. Dadurch wird die oben erwähnte Einschränkung hinsichtlich der Betriebstemperatur unterhalb maximal 100°C deutlich entschärft.

Bei dem erfindungsgemäßen Halbleiterbauelement ist also der Halbleiterkörper durch Reihenschaltung von "Feldstärketrapezen" so gestaltet, daß praktisch beliebige Sperrspannungen erreicht werden können, ohne die Grunddotierung des Halbleiterkörpers und damit auch die intrinsische Temperatur weiter zu reduzieren. Diese Reihenschaltung von "Feldstärketrapezen" ist bei Randstrukturen mit Feldringsystemen vergleichbar, welche als Spannungsteiler für die Raumladungszone wirken.

Vorzugsweise sind die Gebiete des zweiten Leitungstyps so ausgelegt, daß die Raumladungszonen der einzelnen Feldstärketrapeze an die Oberfläche des Halbleiterkörpers bzw. bis zur nächsten "Schicht" der wannenförmig angeordneten Gebiete des zweiten Leitungstyps reichen, um Spitzenwerte des elektrischen Feldes, welche über der kritischen Feldstärke liegen, im Volumen des Halbleiterkörpers zu vermeiden.

Die Kanäle des ersten Leitungstyps, die zwischen den Gebieten des zweiten Leitungstyps geführt sind, verbinden, wie oben erläutert wurde, die durch diese Gebiete geschaffenen Zonen des ersten Leitungstyps, so daß der Betriebsstrom durch die Kanäle fließen kann. Diese Kanäle sollten nun so ausgelegt sein, daß in ihnen keine Spitzen des elektrischen Feldes auftreten.

In den Halbleiterkörper kann noch eine Isolierzone, beispielsweise aus einer Siliziumdioxidschicht, eingebaut werden, um Ladungsträger vom Randbereich des Halbleiterbauelementes abzuschirmen.

Die vorliegende Erfindung ist in bevorzugter Weise auf Dioden, Thyristoren, Transistoren, IGBT's und sonstige bekannte Halbleiter-Leistungsbauelemente anwendbar.

Nachfolgend wird die Erfindung anhand der Zeichnungen näher erläutert. Es zeigen:
- Fig. 1: einen Schnitt durch eine Diode mit strukturiertem Halbleiterkörper und im Randbereich durchgehenden Gebieten des zweiten Leitungstyps,
- Fig. 2: einen Schnitt durch eine Diode mit strukturiertem Halbleiterkörper und im Randbereich unterbrochenen Gebieten des zweiten Leitungstyps,
- Fig. 3: einen Schnitt durch eine Diode mit strukturiertem Halbleiterkörper und im Randbereich durchgehenden Gebieten des zweiten Leitungstyps sowie eingebauter Isolierzone zur Abschirmung der Ladungsträger vom Randbereich,
- Fig. 4: einen Schnitt durch einen MOS-Feldeffekttransistor mit strukturiertem Halbleiterkörper und im Randbereich unterbrochenen Gebieten des zweiten Leitungstyps,
- Fig. 5: einen Schnitt durch einen MOS-Feldeffekttransistor mit strukturiertem Halbleiterkörper und im Randbereich unterbrochenen Gebieten des zweiten Leitungstyps, wobei jedoch im Gegensatz zu dem MOS-Feldeffekttransistor von Fig. 4 keine Feldplatten vorgesehen sind, und
- Fig. 6: einen Schnitt durch einen MOS-Feldeffekttransistor mit einem Injektor.

In den Figuren werden einander entsprechende Teile jeweils mit den gleichen Bezugszeichen versehen. Auch sind in den Figuren zur besseren Darstellung nicht alle geschnittenen Teile tatsächlich schraffiert gezeichnet.

Außerdem können in den dargestellten Ausführungsbeispielen selbstverständlich die jeweiligen Leitungstypen umgekehrt sein.

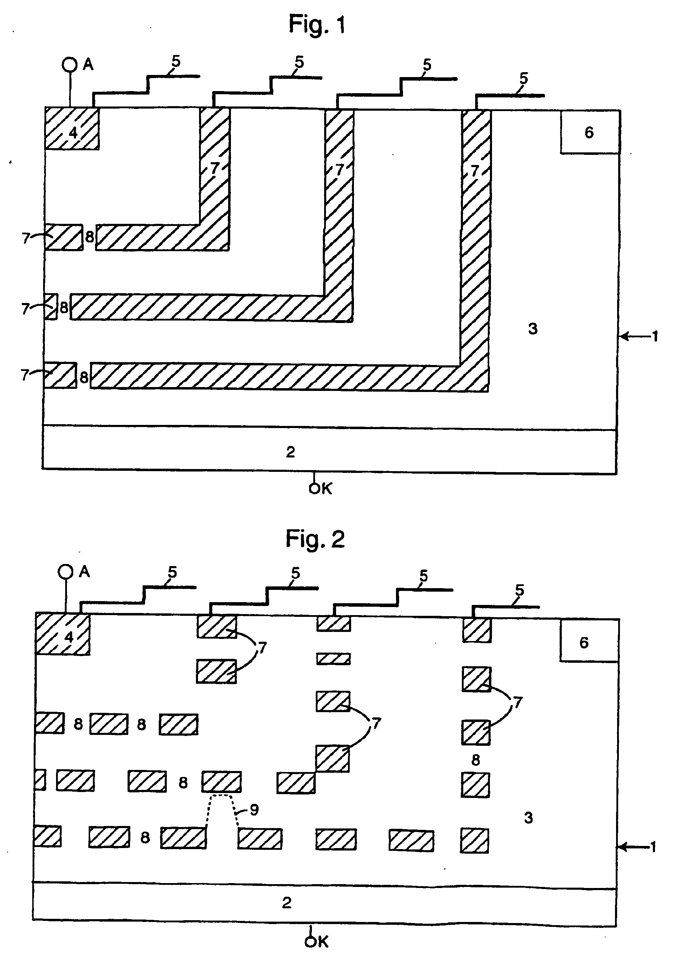

Fig. 1 zeigt einen Halbleiterkörper 1 aus einem n⁺-leitenden Halbleitersubstrat 2 und einer n⁻-leitenden Halbleiterschicht 3 mit einer Grunddotierung, die 5 x 10¹³ Ladungsträger cm⁻³ beträgt oder höher ist.

Eine Kathode K ist mit dem Halbleitersubstrat 2 verbunden, während eine Anode A an eine p⁺-leitende Zone 4 angeschlossen ist.

Feldplatten 5 sind auf der Oberseite des Halbleiterkörpers 1 auf bzw. in einer nicht näher dargestellten Isolierschicht aus beispielsweise Siliziumdioxid vorgesehen. Außerdem ist noch ein n⁺-leitender Schutzring 6 in die den Feldplatten 5 zugewandte Oberfläche des Halbleiterkörpers 1 eingebettet. Dieser Schutzring 6 dient wie die Feldplatten 5 zu einer Erhöhung der Durchbruchsfestigkeit der Diode in deren Randbereich.

Erfindungsgemäß sind nun p-leitende Gebiete 7 vorgesehen, die die Zone 4 im Abstand wannenförmig umgeben und im Driftbereich unterhalb der Zone 4 durch Kanäle 8 unterbrochen sind, durch die der Betriebsstrom zwischen Anode A und Kathode K fließen kann.

Die Gebiete 7 sind so hoch dotiert, daß sie bei Anlegen der Sperrspannung zwischen Anode A und Kathode K an Ladungsträgern im Sperrfall nicht vollständig von Ladungsträgern ausgeräumt werden.

Fig. 2 zeigt ein weiteres Ausführungsbeispiel der Erfindung, das sich vom Ausführungsbeispiel der Fig. 1 dadurch unterscheidet, daß hier die Gebiete 7 auch im Randbereich durch eine Vielzahl von Kanälen 8 unterbrochen sind. Auch ist hier schematisch an einem der Kanäle 8 durch eine Strichlinie 9 ein "Feldstärketrapez" angedeutet. Die Länge dieses Feldstärketrapezes wird durch die Länge des Halbleiterkörpers 1 zwischen den Gebieten 7, also durch die Breite des Kanales 8 des ersten Leitungstyps bestimmt. Das heißt, die Länge des Feldstärketrapezes hängt von dem Abstand zwischen zwei benachbarten Gebieten des zweiten Leitungstyps ab. Durch entsprechende Erhöhung der Anzahl der Gebiete 7 des zweiten Leitungstyps können so praktisch beliebig viele Feldstärketrapeze aneinandergereiht werden, was zu einer entsprechenden Erhöhung der Sperrspannung führt.

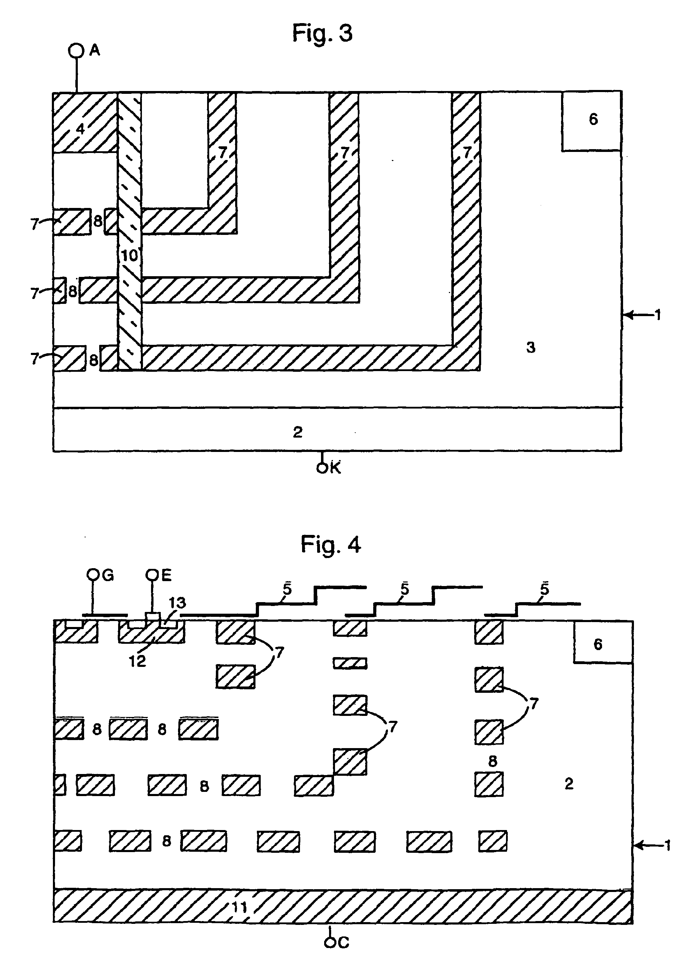

Fig. 3 zeigt ein weiteres Ausführungsbeispiel der Erfindung, bei dem - ähnlich wie im Ausführungsbeispiel von Fig. 1 - im Randbereich die p-leitenden Gebiete 7 durchgehend sind, so daß Kanäle 8 lediglich im Driftbereich der Diode vorhanden sind. Außerdem ist hier noch eine Isolierzone 10 aus beispielsweise Siliziumdioxid vorgesehen, die ringförmig den Bereich unterhalb der Zone 4 umgibt und Ladungsträger vom Randbereich abschirmt. Entsprechend sind Feldplatten 5 bei diesem Ausführungsbeispiel nicht vorgesehen.

Fig. 4 zeigt einen MOS-Feldeffekttransistor mit einer Emitterelektrode E, einer Gateelektrode G und einer Kollektorelektrode C. Die Kollektorelektrode C ist mit einer p⁺-leitenden Zone 11 verbunden, während die Emitterelektrode E an eine p-leitende Zone 12 und eine n-leitende Zone 13 angeschlossen ist und die Gateelektrode G oberhalb von dem durch die Zone 12 gebildeten Kanalbereich liegt und in üblicher Weise von dem Halbleiterkörper durch eine Isolierschicht, beispielsweise aus Siliziumdioxid, getrennt ist. Bei diesem Ausführungsbeispiel umgeben ähnlich wie in Fig. 2 die p-leitenden Gebiete 7 im Abstand wannenförmig die Zonen 12 und 13 und sind dabei jeweils durch Kanäle 8 des Halbleiterkörpers getrennt. Außerdem sind im Randbereich dieses MOS-Feldeffekttransistors noch Feldplatten 5 zur Erhöhung der Durchbruchsfestigkeit vorgesehen.

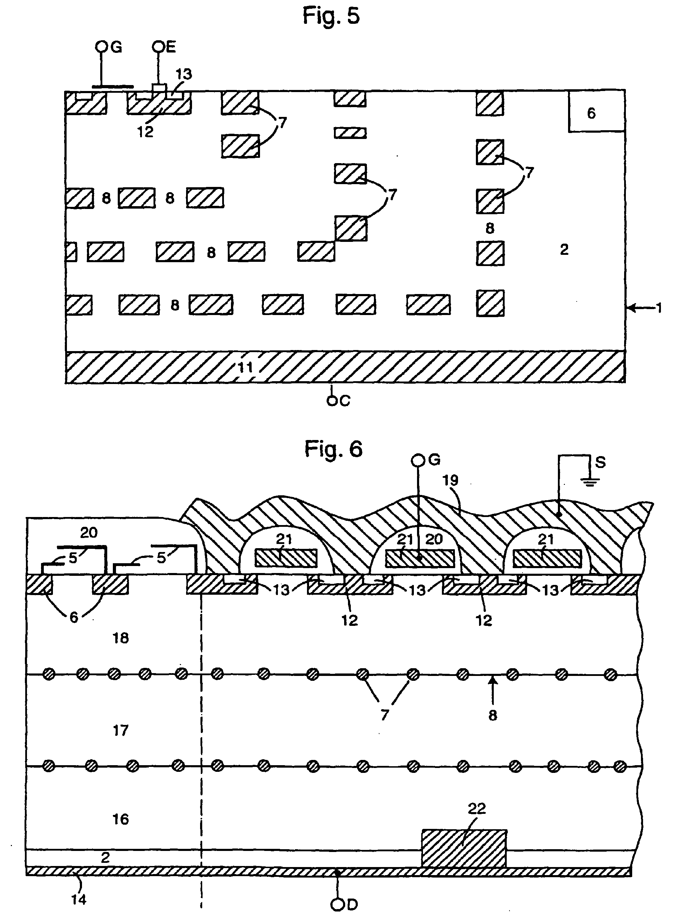

Fig. 5 zeigt ein weiteres Ausführungsbeispiel der Erfindung mit einem MOS-Feldeffekttransistor, der dem MOS-Feldeffekttransistor von Fig. 4 entspricht, jedoch keine Feldplatten 5 aufweist.

Die Feldplatten 5 können, wie in den Fig. 1 und 2 gezeigt ist, mit den p-leitenden Gebieten 7 verbunden werden. Sie können aber auch floatend sein, wie dies in der Fig. 4 dargestellt ist.

Fig. 6 zeigt einen MOS-Feldeffekttransistor, bei dem der Halbleiterkörper anstelle der Halbleiterschicht 3 aus mehreren, verschieden dotierten epitaktischen Schichten 16, 17 und 18 besteht, zwischen denen jeweils die Gebiete 7 beispielsweise durch Ionenimplantation eingebracht sind. In diesem Zusammenhang sei angemerkt, daß auch bei den vorangegangenen Ausführungsbeispielen der Fig. 1 bis 5 die einzelnen Gebiete 7 durch entsprechende Abscheidung einzelner, gleichdotierter Schichten und Ionenimplantationsschritte erzeugt werden können. Außerdem sind im Ausführungsbeispiel der Fig. 6 noch eine Source-Metallisierung 19, eine Isolierschicht 20 aus Siliziumdioxid, Gateelektroden 21 aus beispielsweise dotiertem polykristallinem Silizium und eine p-leitende Zone 22 gezeigt. Anstelle dieser p-leitenden Zone 22 kann auch ein schwacher Injektor, beispielsweise eine Schottky-Sperrschicht vorgesehen werden. Diese Zone 22 kann die gleiche Schichtdicke wie das Substrat 2 haben oder dicker als dieses sein.

## Patentansprüche

1. Halbleiterbauelement mit einem Halbleiterkörper (1) eines ersten Leitungstyps, der eine Dotierungskonzentration über 5 x 10¹³ Ladungsträger cm⁻³ aufweist und auf zwei einander gegenüberliegenden Oberflächen mit jeweils wenigstens einer Elektrode (A,K,E, C) versehen ist, wobei wenigstens eine dieser Elektroden (A,E) eine Halbleiterzone (4,12) eines zweiten, zu dem ersten Leitungstyp entgegengesetzten Leitungstyps kontaktiert, wobei in dem Halbleiterkörper (1) im Abstand zur Zone (4,12) des zweiten Leitungstyps jeweils an wenigstens einer Stelle durch Kanäle (8) des ersten Leitungstyps unterbrochene Gebiete (7) des zweiten Leitungstyps vorgesehen sind, **dadurch gekennzeichnet daß** die Gebiete (7) des zweiten Leitungstyps die Zone (4,12) des zweites Leitungstyps warnenartig wegeben und so hoch dotiert sind, daß sie im Sperrfall des zwischen der Zone (4,12) des zweiten Leitungstyps und dem Halbleiterkörper (1) gebildeten pn-Übergangs an Ladungsträgern nicht vollständig ausgeräumt sind.

2. Halbleiterbauelement nach Anspruch 1,
**dadurch gekennzeichnet,**
**daß** zur Erhöhung der Sperrspannung die Gebiete (7) des zweiten Leitungstyps an mehreren Stellen durch die Kanäle (8) des ersten Leitungstyps unterbrochen sind.

3. Halbleiterbauelement nach Anspruch 1 oder 2,
**dadurch gekennzeichnet,**
**daß** die Kanäle (8) so ausgelegt sind, daß an ihnen keine Spitzen des elektrischen Feldes bei Anlegung der Sperrspannung auftreten.

4. Halbleiterbauelement nach einem der Ansprüche 1 bis 3,
**dadurch gekennzeichnet,**
**daß** die Kanäle (8) in einem Driftbereich des Halbleiterkörpers (1) vorgesehen sind.

5. Halbleiterbauelement nach einem der Ansprüche 1 bis 4,
**dadurch gekennzeichnet,**
**daß** die Kanäle (8) in einem Randbereich des Halbleiterkörpers (1) vorgesehen sind.

6. Halbleiterbauelement nach einem der Ansprüche 1 bis 5,
**gekennzeichnet durch**
eine Isolierzone (10) zur Abschirmung von Ladungsträgern von der Randzone.

7. Halbleiterbauelement nach einem der Ansprüche 1 bis 6,
**dadurch gekennzeichnet,**
**daß** in wenigstens einer Oberfläche ein schwacher Injektor (22), beispielsweise eine Schottky-Sperrschicht, vorgesehen ist.

8. Halbleiterbauelement nach einem der Ansprüche 1 bis 7,
**dadurch gekennzeichnet,**
**daß** auf der die Zone (4,12) des anderen Leitungstyps umgebenden Oberfläche des Halbleiterkörpers (1) Feldplatten (5) vorgesehen sind.

9. Halbleiterbauelement nach einem der Ansprüche 1 bis 8,
**gekennzeichnet durch**
eine den Rand des Halbleiterkörpers umgebende hochdotierte Schutzringzone (6) des einen Leitungstyps.

10. Halbleiterbauelement nach einem der Ansprüche 1 bis 9,
**dadurch gekennzeichnet,**
**daß** der eine Leitungstyp der n-Leitungstyp ist.

11. Halbleiterbauelement nach einem der Ansprüche 1 bis 10,
**dadurch gekennzeichnet,**
**daß** das Halbleiterbauelement eine Diode, ein MOS-Transistor oder ein Thyristor ist.

## Claims

1. Semiconductor component having a semiconductor body (1) of a first conduction type, which has a doping concentration of above 5 x 10¹³ charge carriers cm⁻³ and is provided with in each case at least one electrode (A, K, E, C) on two mutually opposite surfaces, in which case at least one of said electrodes (A, E) makes contact with a semiconductor zone (4, 12) of a second conduction type opposite to the first conduction type,
in which case regions (7) of the second conduction type are provided in the semiconductor body (1), at a distance from the zone (4, 12) of the second conduction type, said regions being interrupted in each case at at least one location by channels (8) of the first conduction type,
**characterized in that** the regions (7) of the second conduction type surround the zone (4, 12) of the second conduction type in a well-like manner and are so highly doped that they are not completely depleted of charge carriers in the case of reverse-biasing of the pn junction formed between the zone (4, 12) of the second conduction type and the semiconductor body (1).

2. Semiconductor component according to Claim 1:
**characterized**
**in that**, in order to increase the reverse voltage, the regions (7) of the second conduction type are interrupted at a plurality of locations by the channels (8) of the first conduction type.

3. Semiconductor component as claimed in claim 1 or 2:
**characterized**
**in that** the channels (8) are designed in such a way that no spikes of the electric field occur at said channels when the reverse voltage is applied.

4. Semiconductor component as claimed in one of claims 1 to 3:
**characterized**
**in that** the channels (8) are provided in a drift region of the semiconductor body (1).

5. Semiconductor component as claimed in one of claims 1 to 4:
**characterized**
**in that** the channels (8) are provided in an edge region of the semiconductor body (1).

6. Semiconductor component as claimed in one of claims 1 to 5:
**characterized**
**by** an insulating zone (10) for shielding charge carriers from the edge zone.

7. Semiconductor component as claimed in one of claims 1 to 6:
**characterized**
**in that** a weak injector (22), for example a Schottky barrier layer, is provided in at least one surface.

8. Semiconductor component as claimed in one of claims 1 to 7:
**characterized**
**in that** field plates (5) are provided on that surface of the semiconductor body (1) which surrounds the zone (4, 12) of the second conduction type.

9. Semiconductor component as claimed in one of claims 1 to 8:
**characterized**
**by** a highly doped guard ring zone (6) of the first conduction type surrounding the edge of the semiconductor body.

10. Semiconductor component as claimed in one of claims 1 to 9:
**characterized**
**in that** the first conduction type is the n conduction type.

11. Semiconductor component as claimed in one of claims 1 to 10:
**characterized**
**in that** the semiconductor component is a diode, a MOS transistor or a thyristor.

## Revendications

1. Composant semi-conducteur comportant un corps semi-conducteur (1) d'un premier type de conduction, à concentration de dopant supérieure à 5 x 10¹³ de porteurs de charge/cm³ et deux surfaces opposées avec chaque fois au moins une électrode (A, K, E, C), dans lequel
au moins l'une des électrodes (A, E) est en contact avec une zone semiconductrice (4, 12) d'un second type de conduction, opposé au premier type de conduction, et
dans le corps semi-conducteur (1), à distance de la zone (4, 12) du second type de conduction, on a chaque fois, en au moins un endroit, des zones (7) coupées par des canaux (8) du premier type de conduction,
**caractérisé en ce que**
les zones (7) du second type de conduction entourent la zone (4, 12) du second type de conduction en forme de cuvette, et sont dopées suffisamment fortement pour qu'en cas de blocage de la jonction pn formée entre la zone (4, 12) du second type de conduction et le corps semi-conducteur (1), les porteurs de charge ne soient pas totalement éliminés.

2. Composant semi-conducteur selon la revendication 1,
**caractérisé en ce que**
pour augmenter la tension de blocage, les zones (7) du second type de conduction sont interrompues en plusieurs endroits par des canaux (8) du premier type de conduction.

3. Composant semi-conducteur selon la revendication 1 ou 2,
**caractérisé en ce que**
les canaux (8) sont conçus pour ne pas avoir de pointe de champ électrique lorsque la tension de blocage est appliquée.

4. Composant semi-conducteur selon l'une des revendications 1 à 3,
**caractérisé en ce que**
les canaux (8) sont prévus dans une zone de dérive du corps semi-conducteur (1).

5. Composant semi-conducteur selon l'une des revendications 1 à 4,
**caractérisé en ce que**
les canaux (8) sont prévus dans une zone marginale du corps semi-conducteur (1) .

6. Composant semi-conducteur selon l'une des revendications 1 à 5,
**caractérisé par**
une zone d'isolation (10) pour protéger les porteurs de charge de la zone marginale.

7. Composant semi-conducteur selon l'une des revendications 1 à 6,
**caractérisé en ce que**
dans au moins une surface supérieure il est prévu un injecteur faible (22), par exemple une couche de blocage Schottky.

8. Composant semi-conducteur selon l'une des revendications 1 à 7,
**caractérisé en ce que**
sur la surface supérieure du corps semi-conducteur (1) entourant la zone (4, 12) de l'autre type de conduction, il y a des plaques de champ (5).

9. Composant semi-conducteur selon l'une des revendications 1 à 8,
**caractérisé par**
une zone annulaire de protection (6) fortement dopée entourant le bord du corps semi-conducteur et correspondant à un type de conduction.

10. Composant semi-conducteur selon l'une des revendications 1 à 9,
**caractérisé en ce que**
le type de conduction est le type de conduction (n).

11. Composant semi-conducteur selon l'une des revendications 1 à 10,
**caractérisé en ce que**
le composant semi-conducteur est une diode, un transistor MOS ou un thyristor.
